# EUROPÄISCHE PATENTSCHRIFT

(11) **EP 2 559 075 B1**
(45) Veröffentlichungstag und Bekanntmachung des Hinweises auf die Patenterteilung: **31.05.2017**
(21) Anmeldenummer: 11703465.2
(22) Anmeldetag: 16.02.2011
(51) Int. Cl.: H01L 31/068, H01L 31/02, H01L 31/0216, H01L 31/0224, H01L 31/18

(54) **VERFAHREN ZUR HERSTELLUNG EINER SOLARZELLE SOWIE NACH DIESEM VERFAHREN HERGESTELLTE SOLARZELLE**
METHOD FOR PRODUCING A SOLAR CELL, AND SOLAR CELL PRODUCED ACCORDING TO THIS METHOD
PROCÉDÉ DE FABRICATION D'UNE CELLULE SOLAIRE ET CELLULE SOLAIRE FABRIQUÉE SELON CE PROCÉDÉ

(30) Priorität: 14.04.2010 DE 102010027742
(43) Veröffentlichungstag der Anmeldung: 20.02.2013
(73) Patentinhaber: SolarWorld Industries Thüringen GmbH, 99310 Arnstadt (DE)
(72) Erfinder: KROKOSZINSKI, Hans-Joachim, 69226 Nußloch (DE)
(74) Vertreter: Isarpatent
(86) Internationale Anmeldenummer: PCT/EP2011/052269
(87) Internationale Veröffentlichungsnummer: WO 2011/128134

(56) Entgegenhaltungen:
- FR-A1- 2 943 180
- C. MORILLA, R. RUSSELL, J.M. FERNANDEZ: "Laser Induced Ablation and Doping Processes on High Efficiency Silicon Solar Cells", PROCEEDINGS OF THE 23RD EUROPEAN PHOTOVOLTAIC SOLAR ENERGY CONFERENCE, 1. September 2008 (2008-09-01), - 5. September 2008 (2008-09-05), Seiten 1506-1509, XP040529071, ISBN: 978-3-936338-24-9
- O. SCHULTZ ET AL: "High-efficiency Solar Cells with Laser-Grooved Buried Contact Front and Laser-Fired Rear for Industrial Production", PROCEEDINGS OF THE 21ST EUROPEAN PHOTOVOLTAIC SOLAR ENERGY CONFERENCE, 4. September 2006 (2006-09-04), - 4. September 2006 (2006-09-04), Seiten 826-829, XP040512290, ISBN: 978-3-936338-20-1
- MATHIAS WEISS ET AL: "Selective Emitter from Structured Diffusion Source Proves its Capability of Industrial Realization", PROCEEDINGS OF THE 24TH EUROPEAN PHOTOVOLTAIC SOLAR ENERGY CONFERENCE, 21. September 2009 (2009-09-21), - 25. September 2009 (2009-09-25), Seiten 1941-1944, XP040530081, ISBN: 978-3-936338-25-6
- FLORIAN CLEMENT ET AL: "Pilot-line processing of screen-printed Cz-Si MWT solar cells exceeding 17% efficiency", PHOTOVOLTAIC SPECIALISTS CONFERENCE (PVSC), 2009 34TH IEEE, IEEE, PISCATAWAY, NJ, USA, 7. Juni 2009 (2009-06-07), Seiten 223-227, XP031626891, ISBN: 978-1-4244-2949-3
- G. POULAIN ET AL: "Towards a Self-Aligned Process for Selective Emitters on Silicon Solar Cells", PROCEEDINGS OF THE 25TH EUROPEAN PHOTOVOLTAIC SOLAR ENERGY CONFERENCE, 6. September 2010 (2010-09-06), - 10. September 2010 (2010-09-10), Seiten 2043-2046, XP040531141, ISBN: 978-3-936338-26-3

## Beschreibung

Die vorliegende Erfindung betrifft ein Verfahren zur Herstellung einer Solarzelle und eine nach einem dieser Verfahren hergestellte Solarzelle.

### Stand der Technik

Silizium-Solarzellen werden seit vielen Jahren auf der Vorderseite mit einer Antireflexionsschicht (Anti-Reflection-Coating), meist aus Siliziumnitrid, versehen, die auch die Oberfläche passiviert. Die Metallisierung durch Silberbahnen erfolgt meistens durch Siebdruck von Silberpasten mit einem gewissen Glasfrittenanteil, der dafür sorgt, dass beim sogenannten Feuern der Paste die Antireflexionsschicht unter der Metallbahn lokal angelöst und punktuell geöffnet wird, so dass die Silberpartikel der Siebdruckpaste an der Oberfläche einen möglichst niederohmigen Kontakt ausbilden können.

Neben der Siebdrucktechnik werden auch Tintenstrahldruck- und Aerosoldrucktechniken sowie Herausdrücken (Dispensen) aus Mikrokanülen sowie laserunterstützte Transferdruckverfahren für die Abscheidung der silberhaltigen Pasten verwendet. Bei der Aerosoldrucktechnik werden dünnflüssige "Tinten" verwendet, die in sehr schmalen, aber sehr flachen Linien aufgesprüht werden. Diese Tinten enthalten neben sehr feinen Silberpartikeln auch einen gewissen Glassfritten-Anteil, um, wie bei den Siebdruckpasten, die Durchkontaktierung des Silbers durch die Passivierungsschicht/ Antireflexionsschicht hindurch zu bewirken. Zur Erreichung der benötigten niedrigen Linienwiderstände muss dann der Querschnitt der Bahnen durch chemisches oder galvanisches Nachverstärken hinreichend weit erhöht werden (siehe M. Hörteis et. al. "Metal aerosol jet printing for solar cell metallization", 12nd EUPVSEC, Mailand, Italien (187)).

Alternativ dazu wird seit kurzem eine Methode erarbeitet, bei der die vorderseitige Passivier-/Antireflexschicht mit Laserablation unter den metallischen Finger entfernt wird, so dass die Siliziumoberfläche direkt mit Nickel unter Bildung von Nickelsilizid metallisiert werden kann.

Alle Verfahren werden auch in Zellen mit einem sogenannten "selektivem Emitter" angewendet. Das bedeutet, dass die für gute Metall-Halbleiter-Kontakte vorteilhafte Dotierkonzentration mit tiefem Diffusionsprofil nur unter den Metallbahnen erzeugt wird, während zwischen den Bahnen eine flachere Dotierung eingebracht wird, um die mit der Dotierkonzentration ansteigende Rekombinationsrate derjenigen Ladungsträgerpaare zu reduzieren, die vom kurzwelligen (blauen) Licht, also in der Nähe der dem Licht zugewandten hochdotierten Oberfläche, erzeugt werden. Damit wird eine höhere Quantenausbeute und damit eine höhere Stromgeneration erreicht.

Ein durch die Firma Suntech entwickeltes Verfahren (siehe Suntech White Paper, "Mass Production of the Innovative Pluto™ Solar Cell Technology", Presentation to the 34th IEEE PV Specialists Conference, Philadelphia, PA - June 189) sieht vor, beim Öffnen der vorderseitigen Antireflexionsschicht/ Passivierungsschicht durch Laserablation die Dotierung der Oberfläche unter den ablatierten Streifen dadurch zu erhöhen, dass das Laserlicht während der Entfernung der Dielektrikumsschicht gleichzeitig den Dotierstoff aus einer vorher auf der Antireflexionsschicht abgeschiedenen Quellschicht in die Oberfläche eintreibt. Damit wird das bekannte Verfahren des Laser-Dotierens mit der Strukturierung der Antireflexionsschicht zu einem einzigen Schritt kombiniert und die Voraussetzung geschaffen, dass die spätere Metallisierung der dünnen Finger z. B. durch direktes Vernickeln selbstjustierend auf den höher dotierten Oberflächenstreifen erfolgt.

Bei diesem sogenannten PLUTO-Prozess muss der auf der Oberfläche abgeschiedene Dotierstoff während der Laserablation durch das zu entfernende Material hindurch in die Oberfläche eingetrieben werden. Dabei muss ein Laser verwendet werden, der derart hohe Energien erzeugen kann. Zudem ist nachteilig, dass hierdurch ein höher Energieaufwand bzw. eine längere Bestrahlungszeit mit dem Laser benötigt wird.
Bei einem alternativen vorbekannten Verfahren für die selektive Dotierung wird das beim flachen homogenen Dotieren der Oberflächen mit Phosphor entstehende Phosphorsilikatglas (PSG) mit Hilfe eines Inkjet-basierten Maskierungsverfahrens strukturiert. Es werden Streifen des PSG in den Bereichen der später aufzubringenden Metallbahnen stehengelassen, und in einem zweiten Hochtemperaturschritt in sauerstoffshaltiger Atmosphäre erfolgt dann aus diesen PSG-Streifen heraus eine zusätzliche, tiefere Dotierung und gleichzeitig Oxidation und Absenken der Oberflächenkonzentration in den umgebenden Oberflächenbereichen.

Bei diesem alternativen Verfahren muss der höher dotierte Streifen deutlich breiter sein als die später zu druckenden Metallbahnen, weil die Justiergenauigkeit darunter leidet, dass die höher dotierten Bereiche im Kamerabild der Sieb- oder Aerosoldrucker nicht sichtbar sind. Dies führt zu einem geringeren Wirkungsgrad der Solarzelle. Zudem muss die Leerlaufspannung der Solarzelle verringert werden.

Die bisher bekannten Verfahren zur Vorderseitenkontaktierung der Solarzelle weisen zudem folgende Nachteile auf: Das bisher standardmäßig verwendete Verfahren zur Herstellung des Metall-Halbleiter-Kontakts der vorderseitigen Metallfinger, das Durchdringen der Antireflexschicht durch die Glasfrittenanteile der Silberpaste, führt zu Kontaktwiderständen, die immer noch einen bedeutenden Beitrag zum gesamten Serienwiderstand der Solarzelle darstellen. Der Anteil der Glasfritte an einer Pasten bzw. Tinte, die eine Antireflexschicht durchdringen muss, ist sehr viel größer als der einer solchen Paste oder Tinte, die den Halbleiter direkt kontaktieren kann. Somit ist auch der Linienwiderstand solcher Pasten bzw. Tinten höher als der reinen Silbers. An allen Grenzflächen zwischen Metall und Halbleiter ist die Rekombinationsgeschwindigkeit der generierten Ladungsträgerpaare im Vergleich zu passivierten Oberflächen praktisch unendlich groß. Bei einer großen Fläche der Metall-Halbleiter-Kontakte muss daher die Leerlaufspannung verringert werden.

Die Druckschrift C. Morilla, R. Russell, J.M. Fernandez: "Laser induced Ablation and Doping Processes on High Efficiency Silicon Solar Cells", Proceedings of the 23rd European Photovaltaic Solar Energy Conference, 1. September 2008 (2008-09-01), - 5. September 2008 (2008-09-05), Seiten 1506-1509 beschreibt ein Verfahren zur Herstellung einer Solarzelle. Diese Solarzelle weist eine im Gebrauchszustand als Lichteinfallsseite dienende erste Hauptoberfläche und eine als Rückseite dienende zweite Hauptoberfläche auf. In der genannten Druckschrift ist ferner der Schritt des Dotierens der ersten Hauptoberfläche mit Phosphor zur Erzeugung einer Phosphordotierschicht, das Entfernen einer durch die Diffusion entstandenen Phosphorsilikatglasschicht, das Aufbringen einer Antireflexions- und Passivierungsschicht und das Abtragen der Antireflexions- und Passivierungsschicht von Teilen der ersten Oberfläche beschrieben. Bei dem lokalen Abtrag der Antireflexschicht und/oder der Passivierungsschicht wird eine gleichzeitige Laserablation und Dotierung der Phosphordotierschicht beschrieben. Die Druckschrift lehrt also, dass die Laserablation mit einer Veränderung des vorherigen Dotierungsprofils verknüpft ist.

Auch die Druckschrift O. Schultz et al: "High-efficiency Solar Cells with Laser-Grooved Buried Contact Front and Laser-Fired Rear for Industrial Production", Proceedings of the 21st European Photovaltaic Solar Energy Conference, 4. September 2006 (2006-09-04), Seiten 826-829 beschreibt eine Solarzelle sowie ein entsprechendes Verfahren zu deren Herstellung.

### Offenbarung der Erfindung

Gegenstand der vorliegenden Erfindung ist gemäß einem ersten Aspekt ein Verfahren zur Herstellung einer Solarzelle aus einem p-dotierten oder n-dotierten Silizium-Substrat, das eine im Gebrauchszustand als Lichteinfallsseite dienende erste Hauptoberfläche und eine als Rückseite dienende zweite Hauptoberfläche aufweist, folgende Schritte umfassend: Dotierung der ersten Hauptoberfläche mit Phosphor, insbesondere durch Diffusion und anschließenden Eintreibschritt, zur Erzeugung einer Phosphordotierschicht in der ersten Hauptoberfläche mit einem über die gesamte erste Hauptoberfläche im Wesentlichen gleichen Konzentrationsprofil und/oder mit einer über die gesamte erste Hauptoberfläche im Wesentlichen gleichen Oberflächenkonzentration, Entfernen einer durch die Diffusion entstandenen Phosphorsilikatglas-Schicht von der ersten Hauptoberfläche und/oder der zweiten Hauptoberfläche, Aufbringen mindestens einer Antireflexionsschicht und/oder Passivierungsschicht, insbesondere SiN oder SiO2/SiN umfassend, auf die erste Hauptoberfläche, und Abtragen der oder jeder Antireflexionsschicht und/oder Passivierungsschicht von Teilen der ersten Hauptoberfläche zur Erzeugung von inselartigen und/oder linienartigen Öffnungen zur Kontaktierung des Silizium-Substrats, wobei die Phosphordotierschicht der ersten Hauptoberfläche beim Abtragen nicht verändert wird.

Vorteilhaft hieran ist, dass auf technisch einfache Art und Weise eine Solarzelle hergestellt wird, bei der durch die klar erkennbaren geöffneten Bereiche auf der ersten Hauptoberfläche die Justage einer Druckform zur Aufbringung von das Silizium-Substrat in den Öffnungen kontaktierenden und die Öffnungen miteinander verbindenden Strukturen sehr leicht durchführbar ist. Hierdurch sinkt die Abschattung der Solarzelle, da eine geringere Fläche der ersten Hauptoberfläche mit Strukturen zur elektrischen Kontaktierung des Silizium-Substrats abgeschattet wird. Zudem wird durch dieses Verfahren technisch einfach eine Solarzelle hergestellt, bei der der Kontaktwiderstand beim Kontaktieren des Silizium-Substrats erniedrigt ist.

Gegenstand der vorliegenden Erfindung ist gemäß einem zweiten Aspekt ein Verfahren zur Herstellung einer Solarzelle aus einem p-dotierten oder n-dotierten Silizium-Substrat, das eine im Gebrauchszustand als Lichteinfallsseite dienende erste Hauptoberfläche und eine als Rückseite dienende zweite Hauptoberfläche aufweist, folgende Schritte umfassend: Dotierung der ersten Hauptoberfläche mit Phosphor, insbesondere durch Diffusion und anschließenden Eintreibschritt, zur Erzeugung einer Phosphordotierschicht in der ersten Hauptoberfläche, Aufbringen einer inselartigen und/oder linienartigen Maskierungsschicht auf die erste Hauptoberfläche, Entfernen einer durch die Diffusion entstandenen Phosphorsilikatglas-Schicht von der ersten Hauptoberfläche und/oder der zweiten Hauptoberfläche, wobei Teile der Phosphorsilikatglas-Schicht durch die Maskierungsschicht geschützt werden, Entfernen der Maskierungsschicht zum Freilegen der geschützten Teile der Phosphorsilikatglas-Schicht auf der ersten Hauptoberfläche, Aufbringen einer oder mehrerer Antireflexionsschichten und/oder Passivierungsschichten, insbesondere SiN oder SiO2/SiN umfassend, auf die erste Hauptoberfläche, und Abtragen der Antireflexionsschichten und/oder Passivierungsschichten von Bereichen der ersten Hauptoberfläche, an denen sich die Phosphorsilikatglas-Schicht unterhalb der Antireflexionsschichten und/oder Passivierungsschichten befindet, zur Erzeugung von inselartigen und/oder linienartigen Öffnungen zur Kontaktierung des Silizium-Substrats, wobei beim Abtragen gleichzeitig Phosphor aus der Phosphorsilikatglas-Schicht, in die erste Hauptoberfläche eingetrieben wird zur Erhöhung einer Phosphorkonzentration in der Phosphordotierschicht und/oder zur Vertiefung der Phosphordotierschicht in der ersten Hauptoberfläche in den Öffnungen.

Vorteilhaft hieran ist, dass auf technisch einfache Art und Weise eine Solarzelle hergestellt wird, bei der durch die klar erkennbaren geöffneten Bereiche auf der ersten Hauptoberfläche die Justage einer Druckform zur Aufbringung von das Silizium-Substrat in den Öffnungen kontaktierenden und die Öffnungen miteinander verbindenden Strukturen sehr leicht durchführbar ist. Hierdurch sinkt die Abschattung der Solarzelle, da eine geringere Fläche der ersten Hauptoberfläche mit Strukturen zur elektrischen Kontaktierung des Silizium-Substrats abgeschattet wird. Zudem wird durch dieses Verfahren technisch einfach eine Solarzelle hergestellt, bei der der Kontaktwiderstand beim Kontaktieren des Silizium-Substrats erniedrigt ist. Darüber hinaus wird durch dieses Verfahren eine Solarzelle hergestellt, die eine lokale, direkte Vorderseitenkontaktierung erlaubt, wobei die Fläche der hochdotierten Bereiche der Vorderseite, und somit Rekombination im Emitterbereich, reduziert wird. Hierdurch kann die Stromgeneration erhöht werden. Dies führt zu einer Erhöhung des Wirkungsgrads der Solarzelle.
Zudem wird durch das Eintreiben des Phosphors aus den lokal verbliebenen Phosphorsilikatglas-Schichten ein zweiter Temperaturschritt erspart. Da dieses Eintreiben u. a. aufgrund des höheren Durchsatzes, insbesondere gegenüber einem Diffusionsofen, kostengünstiger ist, ist dieses Verfahren kostengünstiger gegenüber den bisher bekannten Verfahren mit zwei Diffusionsschritten. Durch die tiefere Dotierschicht der Vorderseite in den Öffnungen gegenüber der restlichen Vorderseite wird zudem die Kurzschlusssicherheit zwischen der Phosphorschicht und dem Silizium-Substrat deutlich verbessert. Darüber hinaus wird das Eintreiben des Phosphors beim aufgezeigten Verfahren erleichtert, da die Phosphorsilikatglas-Schicht, aus der der eingetriebene Phosphor stammt, unterhalb der Antireflexionsschicht/Passivierungsschicht angeordnet ist.

Das Abtragen kann mittels eines Lasers geschehen. Vorteilhaft hieran ist, dass die Verwendung eines Lasers technisch einfach ist und hohe Durchsatzraten erlaubt, wodurch die Kosten noch weiter gesenkt werden. Da die Phosphorsilikatglas-Schicht unterhalb der Antireflexionsschicht/Passivierungsschicht angeordnet ist, kann ein energieärmerer Laserstrahl verwendet werden bzw. die Bestrahlungszeit kann verkürzt werden.

Gemäß einem zweiten Aspekt des Verfahrens werden erfindungsgemäß nach dem Schritt des Abtragens Metallkontaktbahnen zur Kontaktierung des Silizium-Substrats durch eine oder mehrere Öffnungen auf die oder die oberste Antireflexionsschicht und/oder Passivierungsschicht der ersten Hauptoberfläche in einem Abstand D zueinander aufgebracht und die Metallkontaktbahn erhitzt und/oder gesintert. Ein Vorteil hiervon ist, dass technisch einfach das Silizium-Substrat durch die Öffnungen kontaktiert wird. Zugleich wird der spezifische Kontaktwiderstand deutlich verringert. Dies führt zu einer Erhöhung des Zellenwirkungsgrades.

Die Metallkontaktbahnen sind erfindungsgemäß aus einer frittenarmen Paste, die insbesondere mittels Siebdruck- und/oder Dispens-Technik aufgebracht wird, und/oder einer frittenarmen Aerosol-Tinte gebildet, die insbesondere mittels

Aerosol-Druck aufgebracht wird. Durch den frittenarmen Anteil der Metallkontaktbahnen wird der Widerstand der Metallkontaktbahn deutlich herabgesetzt. Aufgrund des geringen Glasanteils der Silberpaste wird der Linienwiderstand der Metallkontaktbahnen reduziert. Hierdurch kann die Stromgeneration erhöht werden und der Gesamtwiderstand erniedrigt werden. Dies führt zu einer weiteren Erhöhung des Zellenwirkungsgrades.

In einer Ausführungsform wird ein Querschnitt der Metallkontaktbahn durch chemische oder galvanische Verstärkung vergrößert. Hierdurch wird der Widerstand der Metallkontaktbahnen noch weiter reduziert.

Die Positionen der Öffnungen können derart festgelegt werden, dass die Öffnung einen Mitte-zu-Mitte-Abstand D zueinander aufweisen, der jeweils einen Wert aufweist, der maximal dem Metallkontaktbahn-Abstand W entspricht, wobei der Mitte-zu-Mitte-Abstand D und der Metallkontaktbahn-Abstand W jeweils einen Wert aufweisen, bei dem ein Wirkungsgrad der Solarzelle maximal ist. Hierdurch wird sichergestellt, dass die Öffnungen und die Metallkontaktbahnen derart angeordnet sind, dass der Wirkungsgrad der Solarzelle maximiert ist.

In einer weiteren Ausführungsform sind die Metallkontaktbahnen derart angeordnet und weisen eine derartige Breite auf, dass die Metallkontaktbahnen die Öffnungen im Wesentlichen vollständig bedecken. Hierdurch wird, insbesondere bei dem Verfahren, bei dem eine tiefer gehende Phosphordotierschicht hergestellt wurde, sichergestellt, dass die hochdotierte Fläche neben den Metallkontaktbahnen nahe bei oder gleich Null ist. Zudem wird durch die Minimierung der Breite der Metallkontaktbahnen auf die Breite der Öffnungen erreicht, dass die Rekombination an der Vorderseite deutlich reduziert wird. Darüber hinaus wird hierdurch die Fläche des metallisierten Anteils verringert, wodurch der Wirkungsgrad der Solarzelle erhöht wird.

Danach kann eine Metallschicht, insbesondere Aluminium umfassend, auf die gesamte zweite Hauptoberfläche zur Rückseitenkontaktierung des Silizium-Substrats aufgebracht werden. Hierdurch wird auf einfache technische Art und Weise die Rückseite der Solarzelle kontaktiert. Vor dem Aufbringen der Metallschicht kann eine Passivierungsschicht mit Öffnungen zum Kontaktieren des Silizium-Substrats auf die zweite Hauptoberfläche aufgebracht werden. Ein Vorteil hiervon ist, dass das Silizium-Substrat gezielt an festgelegten Stellen auf der Rückseite der Solarzelle kontaktiert wird bzw. werden kann.

Bei den Verfahren können ferner Löcher durch das Silizium-Substrat hergestellt werden zur Verbindung der Metallkontaktbahnen der ersten Hauptoberfläche mit der zweiten Hauptoberfläche und/oder Metallkontaktflächen der zweiten Hauptoberfläche. Vorteilhaft hieran ist, dass auf der ersten Hauptoberfläche keine Kontaktierungsvorrichtung angeordnet werden muss, wodurch die Abschattung der ersten Hauptoberfläche der Solarzelle weiter verringert wird.

In einer Ausführungsform werden ferner jeweils mindestens zwei Metallkontaktbahnen verbindende Sammelschienen auf die erste Hauptoberfläche und/oder die zweite Hauptoberfläche aufgebracht. Vorteilhaft hieran ist, dass auf technisch einfache Art und Weise die Metallkontaktbahnen miteinander elektrisch verbunden werden.

Gegenstand der vorliegenden Erfindung ist gemäß einem dritten Aspekt des Weiteren eine Solarzelle aus einem p-dotierten oder n-dotierten Silizium-Substrat, das eine im Gebrauchszustand als Lichteinfallsseite dienende erste Hauptoberfläche und eine als Rückseite dienende zweite Hauptoberfläche aufweist, mit mindestens einer Antireflexionsschicht und/oder Passivierungsschicht auf der ersten Hauptoberfläche, wobei die Antireflexionsschicht und/oder Passivierungsschicht inselartige und/oder linienartige Öffnungen zur Kontaktierung des Silizium-Substrats aufweist, und wobei die erste Hauptoberfläche eine Dotierschicht umfasst, dadurch gekennzeichnet, dass die Dotierschicht mit einem Dotierstoff, insbesondere Phosphor, dotiert ist und ein über die gesamte erste Hauptoberfläche im Wesentlichen gleiches Konzentrationsprofil und/oder eine über die gesamte erste Hauptoberfläche im Wesentlichen gleiche Oberflächenkonzentration aufweist. Vorteilhaft hieran ist, dass durch die klar erkennbaren geöffneten Bereiche auf der ersten Hauptoberfläche die Justage einer Druckform zur Aufbringung von das Silizium-Substrat in den Öffnungen kontaktierenden und die Öffnungen miteinander verbindenden Strukturen sehr leicht durchführbar ist. Hierdurch sinkt die Abschattung der Solarzelle, da eine geringere Fläche der ersten Hauptoberfläche mit Strukturen zur elektrischen Kontaktierung des

Silizium-Substrats abgeschattet wird. Zudem ist der Kontaktwiderstand beim Kontaktieren des Silizium-Substrats erniedrigt.

Bei der Solarzelle gemäß dem dritten Aspekt sind erfindungsgemäß Metallkontaktbahnen auf der Antireflexionsschicht oder Passivierungsschicht mit einem Abstand D zueinander derart angeordnet, dass die Metallkontaktbahnen durch mehrere der Öffnungen mit dem Silizium-Substrat in Kontakt stehen. Auf diese Weise werden die verschiedenen Öffnungen der ersten Hauptoberfläche technisch einfach miteinander elektrisch verbunden.

Bei einer weiteren Ausführungsform der Solarzelle weisen die Öffnungen einen Mitte-zu-Mitte-Abstand D zueinander auf, der jeweils einen Wert aufweist, der maximal dem Metallkontaktbahnen-Abstand W entspricht, wobei der Mitte-zu-Mitte-Abstand D und der Metallkontaktbahnen-Abstand W jeweils einen Wert aufweisen, bei dem ein Wirkungsgrad der Solarzelle maximiert wird. Vorteilhaft hieran ist, dass die Öffnungen und die Metallkontaktbahn derart angeordnet sind, dass der Wirkungsgrad der Solarzelle maximiert ist.

### Zeichnungen

Weitere Vorteile und Zweckmäßigkeiten der Erfindung werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
Fig. 1 eine perspektivische Ansicht einer erfindungsgemäßen Solarzelle mit kreisförmigen Öffnungen in der Passivierungsschicht/Antireflexionsschicht;
Fig. 2 eine perspektivische Ansicht einer erfindungsgemäßen Solarzelle mit rechteckigen Öffnungen in der Passivierungsschicht/Antireflexionsschicht;
Fig. 3 einen Querschnitt des Silizium-Substrats einer erfindungsgemäßen Solarzelle mit einer in den Öffnungen tiefer in das Silizium hineinreichenden Phosphordotierschicht;
Fig. 4a - 4g eine Querschnittsansicht eines Silizium-Substrats nach verschiedenen Schritten eines erfindungsgemäßen Verfahrens;
Fig. 5 eine perspektivische Ansicht eines Silizium-Substrats einer erfindungsgemäßen Solarzelle mit kreisförmigen Öffnungen in der Antireflexionsschicht/Passivierungsschicht, mit die Öffnungen verbindenden Metallbahnen und mit einer Sammelschiene, die die Metallkontaktbahnen elektrisch verbindet;
Fig. 6a eine perspektivische Ansicht eines Silizium-Substrats einer erfindungsgemäßen Solarzelle mit linienartigen Öffnungen in der Antireflexionsschicht /Passivierungsschicht, mit die linienartigen Öffnungen bedeckenden Metallkontaktbahnen und einer Sammelschiene, die die Metallkontaktbahnen elektrisch verbindet;
Fig. 6b eine perspektivische Ansicht eines Silizium-Substrats einer erfindungsgemäßen Solarzelle, die als Metal-Wrap-Through (MWT)-Zelle mit Durchkontaktierungslöchern ausgeführt ist;
Fig. 7 eine Querschnittsansicht eines Silizium-Substrats einer erfindungsgemäßen Solarzelle mit inselförmigen bzw. lokalen Öffnungen auf der ersten Hauptoberfläche und standardmäßiger Siebdruckmetallisierung der zweiten Hauptoberfläche;
Fig. 8 eine Querschnittsansicht eines Silizium-Substrats einer erfindungsgemäßen Solarzelle mit inselförmigen bzw. lokalen Öffnungen auf der ersten Hauptoberfläche und einer passivierten vollflächigen Metallisierung der zweiten Hauptoberfläche mit lokalen Rückseitenkontakten; und
Fig. 9 eine Querschnittsansicht des Silizium-Substrats einer erfindungsgemäßen Solarzelle, die als MWT-Zelle mit Durchkontaktierungslöchern ausgestaltet ist, mit inselförmigen bzw. linienartigen Öffnungen der Antireflexionsschicht/Passivierungsschicht auf der ersten Hauptoberfläche und einer vollflächigen Metallisierung der zweiten Hauptoberfläche mit lokalen Rückseitenkontakten.

Bei der nachfolgenden Beschreibung werden für gleiche und gleich wirkende Teile dieselben Bezugsziffern verwendet.

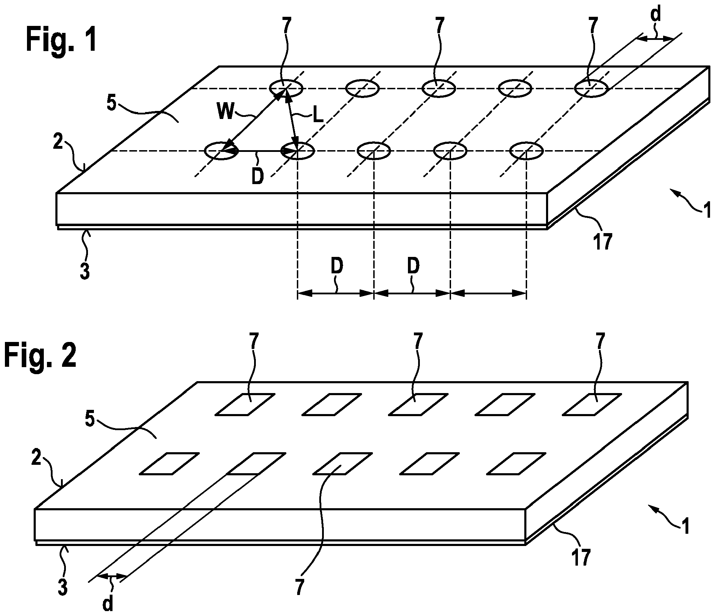

Fig. 1 zeigte einen Querschnitt eines Silizium-Substrats einer erfindungsgemäßen Solarzelle. Das Silizium-Substrat **1** weist eine Vorderseite, erste Hauptoberfläche **2,** die als Lichteinfallsseite im Gebrauchszustand dient, und eine Rückseite, zweite Hauptoberfläche **3,** auf. Das Silizium **4** des Silizium-Substrats **1** ist p- oder n-dotiert. In der ersten Hauptoberfläche **2** befindet sich eine Phosphordotierschicht **5,** die als Teil eines pn-Übergangs oder als Front-Surface-Field dient, je nach Dotierung des Silizium-Substrats **1.**

Auf der ersten Hauptoberfläche **2** befindet sich mindestens eine Antireflexionsschicht/Passivierungsschicht **6.** Diese Schicht bzw. Schichten **6** weisen kreisförmige Öffnungen **7** auf, die einen Mitte-zu-Mitte-Abstand **D** zueinander aufweisen. In den Öffnungen **7** der Passivierungsschicht/Antireflexionsschicht **6** ist die Phosphorkonzentration in der Phosphordotierschicht **5** höher und/oder die Phosphordotierschicht **5** reicht tiefer in die erste Hauptoberfläche **2** des Silizium-Substrats **1** als außerhalb der Öffnungen **7.** Die Öffnungen **7** haben einen Durchmesser der Größe d. Alternativ ist möglich, dass die Phosphordotierung in den Öffnungen **7** gleich der Phosphordotierung der restlichen ersten Hauptoberfläche **2** ist.

Die Flecken bzw. Öffnungen **7** haben entlang der Metallkontaktbahnen **8** einen Abstand **D,** der gemäß der Optimierung der Summe von einzelnen Serienwiderstandsbeiträgen in den Öffnungen **7** und der Abschattung durch die Metallkontaktbahnen **8** maximiert wird. Je nach spezifischem Kontaktwiderstand der Paste in den Öffnungen **7** der Passivierungsschicht **6** kann das Optimum auch bei **D=0,** also bei durchgängig geöffneten, d. h. linienartigen, Streifen bzw. Öffnungen **7** liegen. Folgende Beiträge der Metallkontaktbahnen **8** bis zu einer Sammelschiene **9** bzw. Busbar oder einem Durchkontaktierungsloch **10** einer Metal-Wrap-Through (MWT)-Zelle müssen dabei berücksichtigt werden:
- Querleitungswiderstand in der Phosphordotierschicht **5** (Emitter bzw. Front-Surface-Field) zwischen den Öffnungen **7;** er wächst mit dem Abstand **L** zwischen zwei schräg zu einander liegenden Öffnungen **7,** der vom Abstand **W** der Metallkontaktbahnen **8** und dem Abstand **D** zwischen den Öffnungen **7** abhängt: L² = W² + D². Dabei ist L/2 der maximale Weg, den die generierten Ladungsträger bis zum nächsten Metallkontakt, d. h. Öffnung **7,** zurücklegen müssen, er entspricht also dem halben Abstand, den durchgängig kontaktierende Metallkontaktbahnen bei Standardsolarzellen mit gleichem Vorderseitenschichtwiderstand hätten. Dieser Grenzfall ist D=0, d. h. L=W, d. h. eine Passivierungsschicht/Antireflexionsschicht **6** mit linienartigen Öffnungen **7.**

- Gesamtkontaktwiderstand zwischen den Metallkontaktbahnen und dem Silizium **4** der ersten Hauptoberfläche **2** in den Öffnungen **7.**
- Linienwiderstand entlang der Metallkontaktbahnen **8** bis zum Sammelpunkt auf der Zelle, der Sammelschiene **9** oder dem Durchkontaktierungsloch **10** (bei MWT-Zellen); dieser Beitrag nimmt mit abnehmender Metallkontaktbahnbreite zu und mit zunehmender Metallkontaktbahnhöhe ab.
- Abschattung der ersten Hauptoberfläche **2** durch die Metallkontaktbahnen **8;** diese nimmt mit der Zahl und der Breite der Metallkontaktbahnen **8** zu.
- Beleuchtete Fläche der hochdotierten Bereiche der ersten Hauptoberfläche **2,** die nicht unter, sondern neben den Metallkontaktbahnen **8** liegen; diese erstrecken sich bei Zellen gemäß dem Stand der Technik über die ganze Länge der Finger bzw. Metallkontaktbahnen. In diesen Bereichen ist die Rekombination der Ladungsträgerpaare höher als in den flach dotierten Bereichen, so dass die Stromausbeute reduziert ist. In der erfindungsgemäßen Struktur ist die Gesamtfläche dieser Bereiche gegenüber dem Stand der Technik reduziert. Da die Öffnungen **7,** d. h. die geöffneten Flecken oder Streifen, deutlich sichtbar sind und somit für die Justage des Siebdruckers oder Aerolsoldruckers oder Metallpastendispensers genutzt werden können, kann der Durchmesser der Öffnungen/Flecken **7** oder Breite der Öffnungen/geöffneten Streifen **7** gleich oder kleiner als die Bahnbreite der Metallkontaktbahnen **8** gewählt werden; in diesem Fall ist die hochdotierte Fläche neben den Metallkontaktbahnen **8** sogar gleich Null.
- Rekombination an der ersten Hauptoberfläche **2;** diese nimmt mit dem Anteil der hoch dotierten und metallisierten Oberflächenbereiche an der Gesamtfläche ab. Somit kann die Passivierung der Oberfläche durch Minimierung der Anzahl und Größe der inselartigen Öffnungen **7** bzw. Breite linienartigen Öffnungen **7** verbessert werden.

Die Metallkontaktbahnen **8** verlaufen zum Teil auf der Antireflexionsschicht/ Passivierungsschicht **6** und berühren das Silizium **4** des Silizium-Substrats **1** nur in den Öffnungen **7.** Daher werden die Materialen der Metallkontaktbahnen **8** vorzugsweise daraufhin optimiert, dass mit geringst möglichem Frittengehalt die beste Haftung auf der Antireflexionsschicht/Passivierungsschicht **6** und gleichzeitig der geringst mögliche Kontaktwiderstand in den Öffnungen **7** erreicht werden. Gleichzeitig sollte bei dieser Optimierung geachtet werden, dass die Paste bzw. Tinte die Antireflexionsschicht/Passivierungsschicht **6** nicht durchdringt, sowie dass der unterhalb der Antireflexions-schicht/Passivierungsschicht **6** angeordnete Emitter nicht metallisch durchdrungen und kurzgeschlossen wird, d. h. Shunting vermieden wird.

Die kreisförmigen Öffnungen **7** in Fig. 1 sind entlang zweier Geraden angeordnet, die parallel zueinander verlaufen. Die Geraden haben einen Abstand von W zueinander. Somit berechnet sich ein Abstand zwischen zwei zueinander schräg versetzten Öffnungen **7** der beiden Geraden nach D² + W² = L².

Die zweite Hauptoberfläche **3** des Silizium-Substrats **1** ist mit einem Dotierstoff dotiert, wobei die Dotierschicht ein über die gesamte erste Hauptoberfläche **2** im Wesentlichen gleiches Konzentrationsprofil und/oder eine über die gesamte erste Hauptoberfläche **2** im Wesentlichen gleiche Oberflächenkonzentration aufweist. Zusätzlich kann die zweite Hauptoberfläche **3** mit einer vollflächigen Metallschicht überzogen sein.

Fig. 2 zeigt eine weitere Ausführungsform eines Silizium-Substrats **1** der erfindungsgemäßen Solarzelle, bei der die Öffnungen **7** der Passivierungsschicht/ Antireflexionsschicht **6** eine rechteckige Form aufweisen. Die Breite der rechteckigen Öffnungen **7** beträgt d. Andere Formen der Öffnungen **7,** wie z. B. ellipsenförmig, dreieckig, fünfeckig, vieleckig, inselförmig, etc. sind vorstellbar. In den rechteckigen Öffnungen **7** ist die Phosphorkonzentration in der Phosphordotierschicht **5** erhöht und/oder die Phosphordotierschicht **11** ist tiefer in die erste Hauptoberfläche **2** hineinreichend als in den übrigen Bereichen der ersten Hauptoberfläche **2.**

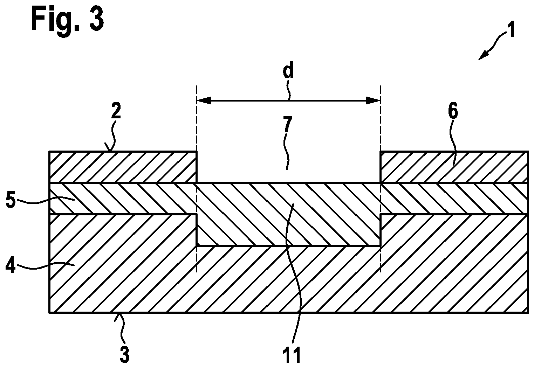

Fig. 3 zeigt einen Querschnitt eines Silizium-Substrats **1** einer erfindungsgemäßen Solarzelle. Die Öffnung **7** weist einen Durchmesser d auf. Auf der ersten Hauptoberfläche **2** des Silizium-Substrats **1** ist mindestens eine Antireflexionsschicht/Passivierungsschicht **6** aufgebracht. In der ersten Hauptoberfläche **2** befindet sich eine Phosphordotierschicht **5,** die ein über die gesamte erste Hauptoberfläche **2** im Wesentlichen gleiches Konzentrationsprofil und/ oder eine über die gesamte erste Hauptoberfläche **2** im Wesentlichen gleiche Oberflächenkonzentration aufweist. An den Stellen der Öffnungen **7** befindet sich eine tiefer in das Silizium hineinreichende Phosphordotierschicht **11.**

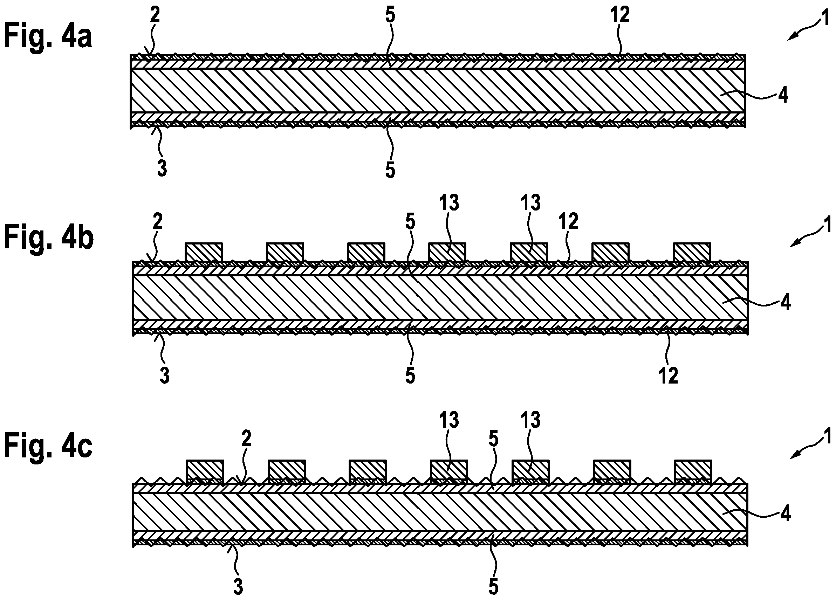

Fig. 4a - 4g zeigen Querschnittsansichten eines Silizium-Substrats **1** nach verschiedenen Schritten eines der erfindungsgemäßen Verfahren. Fig. 4a zeigt eine Querschnittsansicht eines Silizium-Substrats **1** nach einem ersten Verfahrensschritt, bei dem die erste Hauptoberfläche **2** und die zweite Hauptoberfläche **3** mit Phosphor dotiert wurde, um jeweils eine Phosphor-dotierschicht **5** in der jeweiligen Hauptoberfläche **2, 3** zu erzeugen, die ein über die gesamte erste Hauptoberfläche **2** im Wesentlichen gleiches Konzentrationsprofil und/oder eine über die gesamte erste Hauptoberfläche **2** im Wesentlichen gleiche Oberflächenkonzentration aufweist. Bei der Diffusion und dem anschließenden Eintreibschritt ist Phosphorsilikatglas (PSG) in Form einer Schicht **12** auf der ersten Hauptoberfläche **2** und der zweiten Hauptoberfläche **3** entstanden.

Fig. 4b zeigt eine Querschnittsansicht des Silizium-Substrats **1** nach einem nächsten Verfahrensschritt, bei dem eine inselartige und/oder linienartige Maskierungsschicht **13** auf die erste Hauptoberfläche **2** aufgebracht wurde. Die Maskierungsschicht **13** ist insbesondere gegenüber den Säuren im Wesentlichen inert, die im nächsten Verfahrensschritt zum Wegätzen der übrigen PSG-Schicht **12** verwendet werden.

Eine Querschnittsansicht des Silizium-Substrats **1** nach dem nächsten Verfahrensschritt ist in Fig. 4c zu sehen. Bei diesem Verfahrensschritt wurde die PSG-Schicht **12** von der ersten Hauptoberfläche **2** und der zweiten Hauptoberfläche **3** entfernt. Vorzugsweise geschieht dies durch Wegätzen, insbesondere durch ein nasschemisches Verfahren. Die Maskierungsschicht **13** hat die durch sie bedeckten Teile der ersten Hauptoberfläche **2** geschützt, so dass die Phosphorsilikatglas-Schicht **12** unterhalb der Markierungsschicht **13** erhalten geblieben ist, d. h. nicht entfernt wurde.

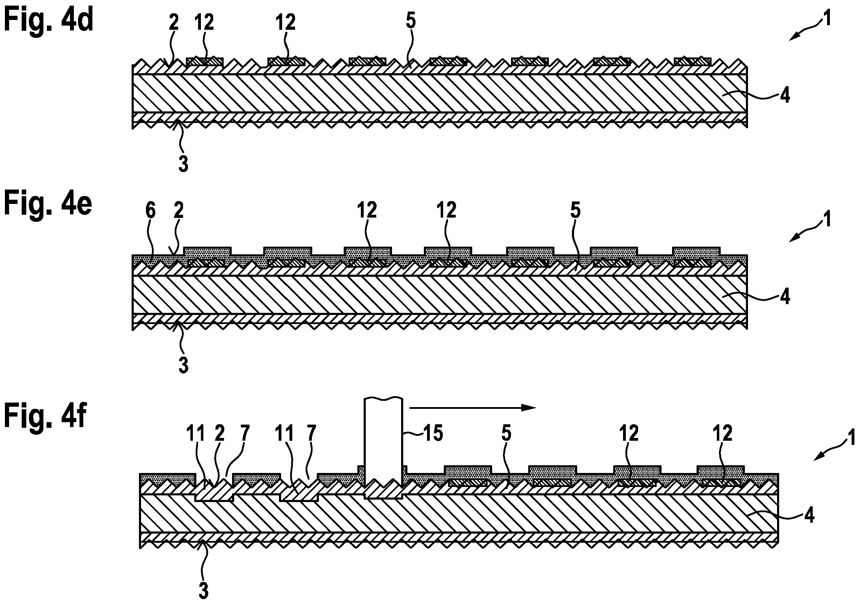

Fig. 4d zeigt eine Querschnittsansicht des Silizium-Substrats **1** nach dem Abtragen der Maskierungsschicht **13.** An den Stellen, an denen sich die Maskierungsschicht **13** befand, befinden sich Reste der PSG-Schicht **12,** sogenannte PSG-Flecken. Nun wird eine oder mehrere Antireflexionsschichten und/ oder Passivierungsschichten **6** auf die erste Hauptoberfläche **2** aufgebracht. Die Antireflexionsschichten und/oder Passivierungsschichten **6** umfassen vorzugsweise SiN oder SiO₂/SiN. Die Schicht oder Schichten **6** werden gleichmäßig auf die erste Hauptoberfläche **2** aufgebracht, so dass an den Stellen, an denen sich Reste der PSG-Schicht **12** befinden, kleine Erhöhungen ausbilden. Das Silizium-Substrat **1** nach diesem Verfahrensschritt ist in Fig. 4e zu sehen.

In Fig. 4f ist der Schritt des Abtragens der Antireflexionsschichten und/oder Passivierungsschichten **6** von Bereichen der ersten Hauptoberfläche **2** zu sehen. Ein Laserstrahl **15** hat bereits zwei erhöhte Stellen der Passivierungsschicht/Antireflexionsschicht **6** bestrahlt und die Passivierungsschicht und/ oder Antireflexionsschicht **6** hierdurch an diesen Stellen entfernt. Dadurch entstehen die Öffnungen **7** und gleichzeitig wird Phosphor aus der PSG-Schicht **12** in das Silizium **4** des Silizium-Substrats **1** getrieben, so dass an den Öffnungen **7** eine tiefer in das Silizium **4** hineinreichende Phosphordotierschicht **11** entsteht. Der Laserstrahl **15** befindet sich in Fig. 4f an der dritten Erhebung, die er gerade bestrahlt. Durch das Bestrahlen wird die PSG-Schicht **12** vollständig entfernt. Die Breite des Laserstrahls **15** entspricht vorzugsweise nahezu der Breite der Erhöhung bzw. der PSG-Flecken **12.**

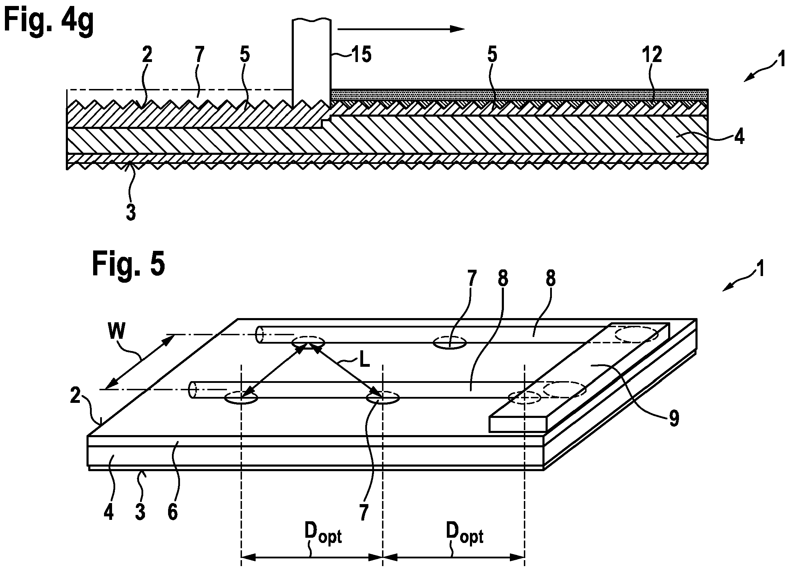

Fig. 4g zeigt eine Querschnittsansicht eines Silizium-Substrats **1** einer erfindungsgemäßen Solarzelle, bei dem linienartige Öffnungen **7** hergestellt werden. Hierzu befinden sich unterhalb der Passivierungsschicht/Antireflexionsschicht **6** nicht nur so genannte PSG-Flecken der PSG-Schicht **12** sondern linienartige Reste der PSG-Schicht **12.** Durch Bestrahlen dieser linienartigen Reste der PSG-Schicht **12** entstehen linienartige Öffnungen **7.** Durch das Bestrahlen wird auch hier Phosphor aus der PSG-Schicht in die erste Hauptoberfläche **2** des Silizium-Substrats **1** eingetrieben. In den linienartigen Öffnungen **7** befindet sich eine tiefer in das Silizium hineinreichende Phosphordotierschicht **11,** die beim Bestrahlen mit dem Laserstrahl **15** entstanden ist. In Fig. 4g ist deutlich zu sehen, dass das ungefähr linke Drittel der gezeigten Solarzelle bereits vom Laserstrahl **15** bestrahlt wurde und er sich von links nach rechts bewegt. Die rechten zwei Drittel in Fig. 4g weisen noch die Passivierungsschicht/Antireflexionsschicht **6** und die PSG-Schicht **12** auf.

Da die geöffneten Flecken oder Streifen **7** deutlich sichtbar sind und somit für die Justage des Siebdruckers oder Aerolsoldruckers oder Metallpastendispensers genutzt werden können, kann der Durchmesser der Flecken oder Breite der geöffneten Streifen **7** gleich oder kleiner als die Bahnbreite der Metallkontaktbahnen **8** gewählt werden, in diesem Fall ist die hochdotierte Fläche neben den Metallkontaktbahnen **8** sogar im Wesentlichen gleich Null.

Rekombination an der Vorderseite **2** nimmt mit dem Anteil der hochdotierten und metallisierten Oberflächenbereiche an der Gesamtfläche ab. Somit kann die Passivierung der Oberfläche durch Minimierung der Anzahl und Größe der Kontaktflecken/Öffnungen **7** bzw. Breite der Metallkontaktbahnen **8** verbessert werden.

Fig. 5 zeigt eine perspektivische Ansicht eines Silizium-Substrats einer erfindungsgemäßen Solarzelle. Die Passivierungsschicht/Antireflexionsschicht **6** der ersten Hauptoberfläche **2** weist kreisrunde Öffnungen **7** auf. Die Öffnungen **7** werden durch Metallkontaktbahnen, die entlang den durch die Öffnungen **7** gebildeten parallelen Geraden verläuft, miteinander elektrisch verbunden. In den Öffnungen **7** kontaktiert die jeweilige Metallkontaktbahn **8** das Silizium **4** bzw. Silizium-Substrat **1.** Die Metallkontaktbahnen **8** bedecken die Öffnungen **7** im Wesentlichen vollständig. In den Öffnungen **7** befindet sich die tiefer in das Silizium hineinreichende Phosphordotierschicht **11,** die durch das Eintreiben von Phosphor aus den PSG-Flecken bzw. aus der PSG-Schicht **12** in die erste Hauptoberfläche **2** mittels der Bestrahlung durch einen Laserstrahl **15** entstanden ist.

Die Metallkontaktbahnen **8** sind durch eine ebenfalls auf der Antireflexionsschicht/Passivierungsschicht **6** angeordnete Sammelschiene **9** miteinander elektrisch verbunden. Die Öffnungen **7** weisen entlang der sie miteinander verbindenden Metallkontaktschienen **8** einen Abstand **Dₒₚₜ** auf. Die Metallkontaktschienen **8** weisen zueinander einen Abstand **W** auf. Der Abstand **D** der Öffnungen **7** zueinander wird vorzugsweise in den Grenzen von 0 mm bis zum Metallkontaktbahnen-Abstand **W** gleichzeitig mit dem Metallkontaktbahnen-Abstand **W** derart optimiert, dass der Wirkungsgrad der Solarzelle maximal wird.

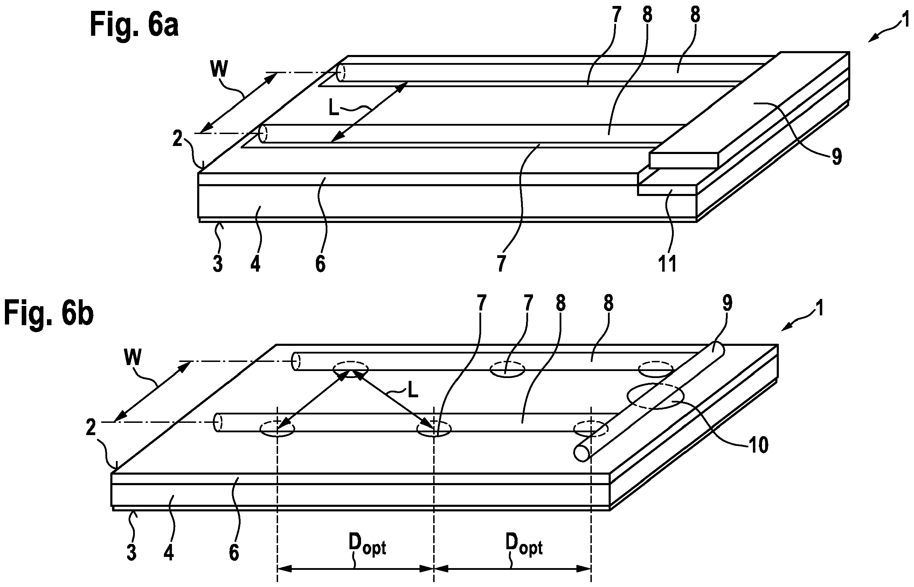

Fig. 6a zeigt eine perspektivische Ansicht eines Silizium-Substrats **1,** das ähnlich zu dem Silizium-Substrat der Fig. 5 ist. Hierbei befinden sich jedoch nicht kreisrunde Öffnungen **7** in der Passivierungsschicht/Antireflexionsschicht **6,** sondern linienartige Öffnungen **7.** Die linienartigen Öffnungen **7** weisen einen Abstand L=W zueinander auf, da der Abstand D der Öffnungen **7** entlang der jeweiligen Metallkontaktbahn **8** gleich Null ist. Die linienartigen Öffnungen **7** sind vollständig durch Metallkontaktbahnen **8** bedeckt. Die Breite der Metallkontaktbahn **8** und der linienartigen Öffnungen **7** stimmen vorzugsweise im Wesentlichen überein. Eine Sammelschiene **9** ist auf der Passivierungsschicht/ Antireflexionsschicht **6** angeordnet und verbindet die Metallkontaktbahnen **8.** Unterhalb der Sammelschiene **9** befindet sich ebenfalls eine tiefer in das Silizium **4** hineinreichende Phosphordotierschicht **11.**

Fig. 6b zeigt eine Querschnittsansicht eines Silizium-Substrats **1** einer erfindungsgemäßen Solarzelle, die als sogenannte Metal-Wrap-Through (MWT)-Zelle ausgeführt ist, mit einem Durchkontaktierungsloch **10.** Auf der ersten Hauptoberfläche **2** sind Metallkontaktbahnen **8** angeordnet. Ebenso sind die Metallkontaktbahnen **8** verbindende Sammelschienen **9** auf der ersten Hauptoberfläche **2** angeordnet. Die erste Hauptoberfläche **2** weist lokale Kontakte mit tiefer Dotierung **16** auf.

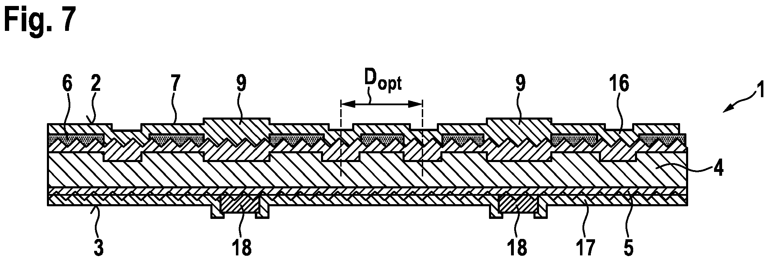

Fig. 7 zeigt eine Querschnittsansicht eines Silizium-Substrats **1** einer erfindungsgemäßen Solarzelle mit inselförmigen bzw. lokalen Öffnungen **7** auf der ersten Hauptoberfläche **2** und standardmäßiger Siebdruckmetallisierung der zweiten Hauptoberfläche **3.** Auf die zweite Hauptoberfläche **3** ist eine Metallschicht **17** aufgebracht. Ebenfalls auf der zweiten Hauptoberfläche **3** sind Lötkontaktflächen **18** bzw. Lötpads angeordnet.

In einer weiteren Ausführungsform kann die Metallschicht **17** durch eine dielektrische Zwischenschicht von der zweiten Hauptoberfläche getrennt (isoliert) sein.

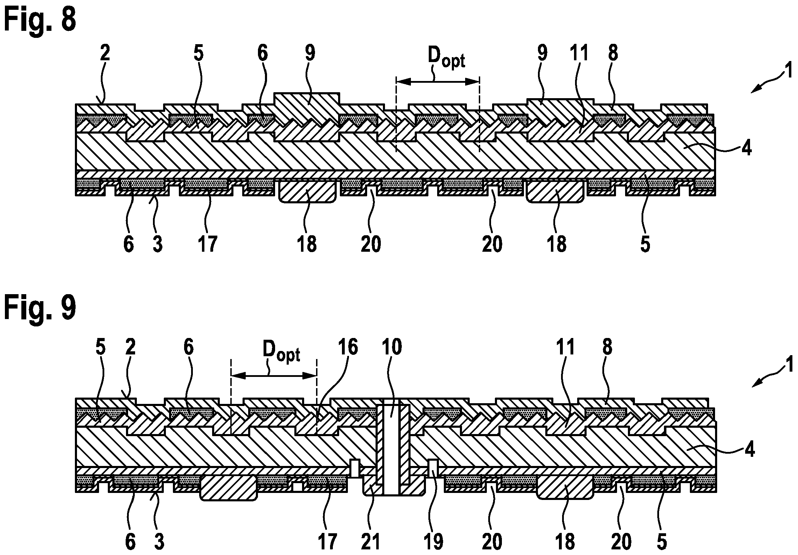

Diese Variante kann ebenfalls als beidseitig kontaktierte Solarzelle (siehe Fig. 8) oder als rückseitig kontaktierte Solarzelle vom Metal-Wrap-Through-Typ (siehe Fig. 9) ausgeführt sein.

Fig. 9 zeigt eine Querschnittsansicht eines Silizium-Substrat **1** einer erfindungsgemäßen Solarzelle mit lokalen inselförmigen oder linienartigen Öffnungen **7** auf der ersten Hauptoberfläche **2** und einer passivierten vollflächigen Metallschicht **17** auf der zweiten Hauptoberfläche **3.** Die Metallschicht **17** umfasst vorzugsweise Aluminium und wird bevorzugt mittels Aufdampfen oder Sputtern aufgetragen. Auf der zweiten Hauptoberfläche **2** sind lokale Rückseitenkontakte **20** angeordnet.

Durch das Silizium-Substrat **1** verläuft ein Via **10,** d. h. eine Verbindung von der ersten Hauptoberfläche **2** zu der zweiten Hauptoberfläche **3.** Dieses Via **10** ist mit einer Metallschicht beschichtet. Die lokalen Kontakte mit tiefer Dotierung **16** der ersten Hauptoberfläche **2** stehen über die Metallkontaktbahnen **8** und die Sammelschienen **9** in elektrischem Kontakt mit dieser Beschichtung des Vias **10** und den Lötkontaktflächen **21** (Pads) auf der zweiten Hauptoberfläche **3.** Dort befinden sich benachbart Isolationsgräben **19,** die das Pad **21** von der Metallschicht **17** der zweiten Hauptoberfläche **3** isolieren.

Für die Verbindung der Zellen in Modulen kann entweder das Aluminium mittels Löten, Bonden oder Schweißen direkt mit Zellverbindern verbunden werden, oder es können in der Aluminiumfläche oder auch darauf lötfähige Kontaktbereiche, also Sammelschienen **9** oder Lötkontaktflächen **18, 21,** erzeugt werden. Die Aluminium-Metallisierung kann das Silizium-Substrat **1** entweder vollflächig oder, wenn sie auf einer Passivierungsschicht **6** abgeschieden wurde, nur lokal in den erfindungsgemäßen Öffnungen **7** in der Passivierungsschicht **6** kontaktieren. In beiden Fällen kann die großflächige Rückseitenmetallschicht **17** mit einer dielektrischen Schicht abgedeckt sein, die nur in den Bereichen der Sammelschienen **9** oder Lötkontaktflächen **18** mit geeigneten Ätzmethoden wieder geöffnet wird.

An dieser Stelle sei darauf hingewiesen, dass alle oben beschriebenen Schritte des Verfahrens für sich alleine gesehen und in jeder Kombination, insbesondere die in den Zeichnungen dargestellten Details, als erfindungswesentlich beansprucht werden. Abänderungen hiervon sind dem Fachmann geläufig.

Im Übrigen ist die Ausführung der Erfindung nicht auf die oben beschriebenen Beispiele und hervorgehobenen Aspekte beschränkt, sondern lediglich durch den Schutzbereich der anhängenden Patentansprüche.

## Patentansprüche

1. Verfahren zur Herstellung einer Solarzelle aus einem p-dotierten oder n-dotierten Silizium-Substrat (1), das eine im Gebrauchszustand als Lichteinfallsseite dienende erste Hauptoberfläche (2) und eine als Rückseite dienende zweite Hauptoberfläche (3) aufweist, folgende Schritte aufweisend:
- Dotierung der ersten Hauptoberfläche (2) mit Phosphor, insbesondere durch Diffusion und anschließenden Eintreibschritt, zur Erzeugung einer Phosphordotierschicht (5) in der ersten Hauptoberfläche (2) mit einem über die gesamte erste Hauptoberfläche (2) im Wesentlichen gleichen Konzentrationsprofil und/oder mit einer über die gesamte erste Hauptoberfläche (2) im Wesentlichen gleichen Oberflächenkonzentration,
- Entfernen einer durch die Diffusion entstandenen Phosphorsilikatglas-Schicht (12) von der ersten Hauptoberfläche (2) und/oder der zweiten Hauptoberfläche (3),
- Aufbringen mindestens einer Antireflexionsschicht und/oder Passivierungsschicht (6), insbesondere SiN oder SiO2/SiN umfassend, auf die erste Hauptoberfläche (2), und
- Abtragen der oder jeder Antireflexionsschicht und/oder Passivierungsschicht (6) von Teilen der ersten Hauptoberfläche (2) zur Erzeugung von inselartigen und/oder linienartigen Öffnungen (7) zur Kontaktierung des Silizium-Substrats (1), wobei die Phosphordotierschicht (5) der ersten Hauptoberfläche (2) beim Abtragen nicht verändert wird.

2. Verfahren zur Herstellung einer Solarzelle aus einem p-dotierten oder n-dotierten Silizium-Substrat (1), das eine im Gebrauchszustand als Lichteinfallsseite dienende erste Hauptoberfläche (2) und eine als Rückseite dienende zweite Hauptoberfläche (3) aufweist, folgende Schritte aufweisend:
- Dotierung der ersten Hauptoberfläche (2) mit Phosphor, insbesondere durch Diffusion und anschließenden Eintreibschritt, zur Erzeugung einer Phosphordotierschicht (5) in der ersten Hauptoberfläche (2),
- Aufbringen einer inselartigen und/oder linienartigen Maskierungsschicht (13) auf die erste Hauptoberfläche (2),
- Entfernen einer durch die Diffusion entstandenen Phosphorsilikatglas-Schicht (12) von der ersten Hauptoberfläche (2) und/oder der zweiten Hauptoberfläche (3), wobei Teile der Phosphorsilikatglas-Schicht (12) durch die Maskierungsschicht (13) geschützt werden,
- Entfernen der Maskierungsschicht (13) zum Freilegen der geschützten Teile der Phosphorsilikatglas-Schicht (12) auf der ersten Hauptoberfläche (2),
- Aufbringen einer oder mehrerer Antireflexionsschichten und/oder Passivierungsschichten (6), insbesondere SiN oder SiO2/SiN umfassend, auf die erste Hauptoberfläche (2), und
- Abtragen der Antireflexionsschichten und/oder Passivierungsschichten von Bereichen der ersten Hauptoberfläche (2), an denen sich die Phosphorsilikatglas-Schicht unterhalb der Antireflexionsschichten und/oder Passivierungsschichten befindet, zur Erzeugung von inselartigen und/oder linienartigen Öffnungen (7) zur Kontaktierung des Silizium-Substrats (1), wobei beim Abtragen gleichzeitig Phosphor aus der Phosphorsilikatglas-Schicht (12) in die erste Hauptoberfläche (2) eingetrieben wird zur Erhöhung einer Phosphorkonzentration in der Phosphordotierschicht (5) und/oder zur Vertiefung der Phosphordotierschicht (5) in der ersten Hauptoberfläche (2) in den Öffnungen (7), wobei nach dem Schritt des Abtragens Metallkontaktbahnen (8) zur Kontaktierung des Silizium-Substrats (1) aus einer frittenarmen Paste, die insbesondere mittels Siebdruck- und/oder Dispense-Technik aufgebracht wird, durch eine oder mehrere der Öffnungen (7) auf die oder die oberste Antireflexionsschicht und/oder Passivierungsschicht (6) der ersten Hauptoberfläche (2) in einem Abstand W zueinander aufgebracht und die Metallkontaktbahnen (8) erhitzt und/oder gesintert werden

3. Verfahren nach Anspruch 1 oder 2, wobei das Abtragen mittels eines Lasers (15) geschieht.

4. Verfahren nach Anspruch 2 oder 3, wobei ein Querschnitt der Metallkontaktbahnen (8) durch chemische oder galvanische Verstärkung vergrößert wird.

5. Verfahren nach einem der Ansprüche 2 bis 4, wobei Positionen der Öffnungen (7) derart festgelegt werden, dass die Öffnungen (7) einen Mitte-zu-Mitte-Abstand D zueinander aufweisen, der jeweils einen Wert aufweist, der maximal dem Metallkontaktbahnen-Abstand W entspricht, wobei der Mitte-zu-Mitte-Abstand D und der Metallkontaktbahnen-Abstand W jeweils einen Wert aufweisen, bei dem ein Wirkungsgrad der Solarzelle maximal ist.

6. Verfahren nach einem der Ansprüche 2 bis 5, wobei die Metallkontaktbahnen (8) derart angeordnet werden und eine derartige Breite aufweisen, dass die Metallkontaktbahnen (8) die Öffnungen (7) im Wesentlichen vollständig bedecken.

7. Verfahren nach einem der vorhergehenden Ansprüche, wobei ferner eine Metallschicht (17), insbesondere Aluminium umfassend, auf die gesamte zweite Hauptoberfläche (3) zur Rückseitenkontaktierung des Silizium-Substrats (1) aufgebracht wird.

8. Verfahren nach Anspruch 7, wobei ferner vor dem Aufbringen der Metallschicht (17) eine Passivierungsschicht (6) mit Öffnungen zum Kontaktieren des Silizium-Substrats auf die zweite Hauptoberfläche (3) aufgebracht wird.

9. Verfahren nach einem der Ansprüche 2 bis 8, wobei ferner Löcher (10) durch das Silizium-Substrat (1) hergestellt werden zur Verbindung der Metallkontaktbahnen (8) der ersten Hauptoberfläche (2) mit der zweiten Hauptoberfläche (3) und/oder Metallkontaktflächen (21) der zweiten Hauptoberfläche.

10. Verfahren nach einem der Ansprüche 2 bis 9, wobei ferner jeweils mindestens zwei Metallkontaktbahnen (8) verbindende Sammelschienen (9) auf die erste Hauptoberfläche (2) und/oder die zweite Hauptoberfläche (3) aufgebracht werden.

11. Solarzelle aus einem p-dotierten oder n-dotierten Silizium-Substrat (1), das eine im Gebrauchszustand als Lichteinfallsseite dienende erste Hauptoberfläche (2) und eine als Rückseite dienende zweite Hauptoberfläche (3) aufweist, mit mindestens einer Antireflexionsschicht und/oder Passivierungsschicht (6) auf der ersten Hauptoberfläche (2), wobei die Antireflexionsschicht und/oder Passivierungsschicht (6) inselartige und/oder linienartige Öffnungen (7) zur Kontaktierung des Silizium-Substrats (1) aufweist, und wobei die erste Hauptoberfläche (2) eine Dotierschicht umfasst, wobei die Dotierschicht mit einem Dotierstoff, insbesondere Phosphor, dotiert ist und ein über die gesamte erste Hauptoberfläche (2) im Wesentlichen gleiches Konzentrationsprofil und/oder eine über die gesamte erste Hauptoberfläche (2) gleiche Oberflächenkonzentration aufweist, **gekennzeichnet durch** Metallkontaktbahnen (8) auf der Antireflexionsschicht oder Passivierungsschicht (6) mit einem Abstand W zueinander derart angeordnet sind, dass die Metallkontaktbahnen (8) durch mehrere der Öffnungen (7) mit dem Silizium-Substrat in Kontakt stehen.

12. Solarzelle nach Anspruch 11, wobei die Öffnungen (7) einen Mitte-zu-Mitte-Abstand D zueinander aufweisen, der jeweils einen Wert aufweist, der maximal dem Metallkontaktbahnen-Abstand W entspricht, wobei der Mitte-zu-Mitte-Abstand D und der Metallkontaktbahnen-Abstand W jeweils einen Wert aufweisen, bei dem ein Wirkungsgrad der Solarzelle maximal ist.

## Claims

1. Method for producing a solar cell consisting of a p-doped or n-doped silicon substrate (1), which comprises a first major surface (2) used as a light incident side during use and a second major surface (3) used as a rear side, the method comprising the following steps:
- doping the first major surface (2) with phosphorus, in particular by diffusion and subsequent driving-in step, for generating a phosphorus-doped layer (5) in the first major surface (2) having a substantially identical concentration profile over the entire first major surface (2) and/or having a substantially identical surface concentration over the entire first major surface (2),
- removing a phosphorus silicate glass layer (12) obtained by the diffusion from the first major surface (2) and/or the second major surface (3),
- applying at least one antireflection layer and/or passivation layer (6), in particular comprising SiN or SiO₂/SiN, to the first major surface (2), and
- stripping the or each antireflection layer and/or passivation layer (6) from parts of the first major surface (2) to produce island-like and/or linear openings (7) for contacting the silicon substrate (1), wherein the phosphorus-doped layer (5) of the first major surface (2) is not altered during stripping.

2. Method for producing a solar cell consisting of a p-doped or n-doped silicon substrate (1), which comprises a first major surface (2) used as a light incident side during use and a second major surface (3) used as a rear side, the method comprising the following steps:
- doping the first major surface (2) with phosphorus, in particular by diffusion and subsequent driving-in step, for generating a phosphorus-doped layer (5) in the first major surface (2),
- applying an island-like and/or linear masking layer (13) to the first major surface (2),
- removing a phosphorus silicate glass layer (12) obtained by the diffusion from the first major surface (2) and/or the second major surface (3), wherein parts of the phosphorus silicate glass layer (12) are protected by the masking layer (13),
- removing the masking layer (13) in order to expose the protected parts of the phosphorus silicate glass layer (12) on the first major surface (2),
- applying one or more antireflection layers and/or passivation layers (6), in particular comprising SiN or SiO₂/SiN, to the first major surface (2), and
- stripping the antireflection layers and/or passivation layers from regions of the first major surface (2) at which the phosphorus silicate glass layer is located beneath the antireflection layers and/or passivation layers to produce island-like and/or linear openings (7) for contacting the silicon substrate (1), wherein, during stripping, phosphorus from the phosphorus silicate glass layer (12) is simultaneously driven into the first major surface (2) in order to increase a phosphorus concentration in the phosphorus-doped layer (5) and/or for deepening the phosphorus-doped layer (5) in the first major surface (2) in the openings (7), wherein, after the step of stripping, metal contact strips (8) for contacting the silicon substrate (1) consisting of a low-frit paste, which is applied in particular by means of a screen printing technique and/or dispensing technique, are applied through one or more of the openings (7) on the or the uppermost antireflection layer and/or passivation layer (6) of the first major surface (2) at a distance W to each other, and the metal contact strips (8) are heated and/or sintered.

3. Method as claimed in claim 1 or 2, wherein stripping occurs by means of a laser (15).

4. Method as claimed in claim 2 or 3, wherein a cross-section of the metal contact strips (8) is enlarged by chemical or galvanic reinforcement.

5. Method as claimed in any one of claims 2 to 4, wherein positions of the openings (7) are fixed such that the openings (7) have a centre-to-centre distance D to each other which has a value which is at most equal to the metal contact strips distance W, wherein the centre-to-centre distance D and the metal contact strips distance W each have a value at which a degree of efficiency of the solar cell is at a maximum.

6. Method as claimed in any one of claims 2 to 5, wherein the metal contact strips (8) are arranged such that, and have a width such that, the metal contact strips (8) substantially completely cover the openings (7).

7. Method as claimed in any one of the preceding claims, wherein furthermore a metal layer (17), in particular comprising aluminium, is applied to the entire second major surface (3) for contacting the silicon substrate (1) on the rear side.

8. Method as claimed in claim 7, wherein furthermore, prior to applying the metal layer (17), a passivation layer (6) having openings for contacting the silicon substrate is applied to the second major surface (3).

9. Method as claimed in any one of claims 2 to 8, wherein furthermore holes (10) are produced through the silicon substrate (1) for connecting the metal contact strips (8) of the first major surface (2) to the second major surface (3) and/or metal contact strips (21) of the second major surface.

10. Method as claimed in any one of claims 2 to 9, wherein furthermore in each case busbars (9) connecting at least two metal contact strips (8) are attached to the first major surface (2) and/or the second major surface (3).

11. Solar cell consisting of a p-doped or n-doped silicon substrate (1) which comprises a first major surface (2) used as a light incidence side during use and a second major surface (3) used as a rear side, having at least one antireflection layer and/or passivation layer (6) on the first major surface (2), wherein the antireflection layer and/or passivation layer (6) comprise(s) island-like and/or linear openings (7) for contacting the silicon substrate (1), and wherein the first major surface (2) comprises a doped layer, wherein the doped layer is doped with a dopant, in particular phosphorus, and has a substantially identical concentration profile over the entire first major surface (2) and/or an identical surface concentration over the entire first major surface (2), **characterised by** metal contact strips (8) being arranged on the antireflection layer or passivation layer (6) at a distance W to each other such that the metal contact strips (8) are in contact with the silicon substrate through some of the openings (7).

12. Solar cell as claimed in claim 11, wherein the openings (7) have a centre-to-centre distance D to each other which has a value which is at most equal to the metal contact strips distance W, wherein the centre-to-centre distance D and the metal contact strips distance W each have a value at which a degree of efficiency of the solar cell is at a maximum.

## Revendications

1. Procédé de fabrication d'une cellule solaire à partir d'un substrat de silicium (1) dopé P ou dopé N, qui comporte une première surface principale (2) servant de côté d'incidence de la lumière à l'état d'utilisation et une seconde surface principale (3) servant de côté arrière, comportant les étapes suivantes consistant à :
- doper la première surface principale (2) avec du phosphore, en particulier par diffusion suivie d'une étape d'enfoncement, afin de générer une couche dopée au phosphore (5) dans la première surface principale (2) avec sensiblement un même profil de concentration sur toute la première surface principale (2) et/ou avec sensiblement une même concentration superficielle sur toute la première surface principale (2),
- éliminer de la première surface principale (2) et/ou de la seconde surface principale (3) une couche de verre de phosphosilicate (12) obtenue par la diffusion,
- appliquer au moins une couche antireflet et/ou une couche de passivation (6), en particulier comprenant du SiN ou du SiO₂/SiN, sur la première surface principale (2), et
- enlever la ou chaque couche antireflet et/ou couche de passivation (6) de parties de la première surface principale (2) afin de générer des ouvertures (7) en forme d'îlots et/ou en forme de lignes pour la connexion du substrat de silicium (1), la couche dopée au phosphore (5) de la première surface principale (2) n'étant pas modifiée lors de l'enlèvement.

2. Procédé de fabrication d'une cellule solaire à partir d'un substrat de silicium (1) dopé P ou dopé N, qui comporte une première surface principale (2) servant de côté d'incidence de la lumière à l'état d'utilisation et une seconde surface principale (3) servant de côté arrière, comportant les étapes suivantes consistant à :
- doper la première surface principale (2) avec du phosphore, en particulier par diffusion suivie d'une étape d'enfoncement, afin de générer une couche dopée au phosphore (5) dans la première surface principale (2),
- appliquer une couche de masquage (13) en forme d'îlots et/ou en forme de lignes sur la première surface principale (2),
- éliminer de la première surface principale (2) et/ou de la seconde surface principale (3) une couche de verre de phosphosilicate (12) obtenue par la diffusion, des parties de la couche de verre de phosphosilicate (12) étant protégées par la couche de masquage (13),
- éliminer la couche de masquage (13) pour exposer les parties protégées de la couche de verre de phosphosilicate (12) sur la première surface principale (2),
- appliquer une ou plusieurs couches antireflets et/ou couches de passivation (6), en particulier comprenant du SiN ou du SiO₂/SiN, sur la première surface principale (2), et
- enlever les couches antireflets et/ou les couches de passivation de zones de la première surface principale (2), dans lesquelles la couche de verre de phosphosilicate se trouve sous les couches antireflets et/ou les couches de passivation, afin de générer des ouvertures (7) en forme d'îlots et/ou en forme de lignes pour connecter le substrat de silicium (1), dans lequel, lors de l'enlèvement, du phosphore est simultanément enfoncé depuis la couche de verre de phosphosilicate (12) dans la première surface principale (2) pour augmenter une concentration en phosphore dans la couche dopée au phosphore (5) et/ou pour approfondir la couche dopée au phosphore (5) dans la première surface principale (2) dans les ouvertures (7), dans lequel, après l'étape d'enlèvement, des voies de contact métalliques (8) pour la connexion du substrat de silicium (1) constituées d'une pâte pauvre en fritte, qui est appliquée en particulier selon une technique de sérigraphie et/ou de distribution, sont appliquées par une ou plusieurs des ouvertures (7) sur la couche antireflet et/ou la couche de passivation (6) ou la couche antireflet supérieure et/ou la couche de passivation supérieure (6) de la première surface principale (2) avec un écart W entre elles et les voies de contact métalliques (8) sont chauffées et/ou frittées.

3. Procédé selon la revendication 1 ou 2, dans lequel l'enlèvement est effectué au moyen d'un laser (15).

4. Procédé selon la revendication 2 ou 3, dans lequel une section transversale des voies de contact métalliques (8) est agrandie par renforcement chimique ou galvanique.

5. Procédé selon l'une des revendications 2 à 4, dans lequel des positions des ouvertures (7) sont définies de telle manière que les ouvertures (7) présentent un écart de centre à centre D entre elles qui présente respectivement une valeur qui correspond au maximum à l'écart W entre les voies de contact métalliques, l'écart de centre à centre D et l'écart W entre les voies de contact métalliques présentant respectivement une valeur avec laquelle un rendement de la cellule solaire est maximal.

6. Procédé selon l'une des revendications 2 à 5, dans lequel les voies de contact métalliques (8) sont disposées de telle manière et présentent une telle largeur que les voies de contact métalliques (8) recouvrent sensiblement complètement les ouvertures (7).

7. Procédé selon l'une des revendications précédentes, dans lequel en outre une couche métallique (17), comprenant en particulier de l'aluminium, est appliquée sur toute la seconde surface principale (3) pour la connexion du côté arrière du substrat de silicium (1).

8. Procédé selon la revendication 7, dans lequel en outre une couche de passivation (6) avec des ouvertures pour la connexion du substrat de silicium est appliquée sur la seconde surface principale (3) avant l'application de la couche métallique (17).

9. Procédé selon l'une des revendications 2 à 8, dans lequel en outre des trous (10) sont formés à travers le substrat de silicium (1), pour relier les voies de contact métalliques (8) de la première surface principale (2) à la seconde surface principale (3) et/ou à des surfaces de contact métalliques (21) de la seconde surface principale.

10. Procédé selon l'une des revendications 2 à 9, dans lequel en outre des barres collectrices (9) reliant respectivement au moins deux voies de contact métalliques (8) sont appliquées sur la première surface principale (2) et/ou la seconde surface principale (3).

11. Cellule solaire constituée d'un substrat de silicium (1) dopé P ou dopé N, qui comporte une première surface principale (2) servant de côté d'incidence de la lumière à l'état d'utilisation et une seconde surface principale (3) servant de côté arrière, comprenant au moins une couche antireflet et/ou une couche de passivation (6) sur la première surface principale (2), la couche antireflet et/ou la couche de passivation (6) comportant des ouvertures (7) en forme d'îlots et/ou en forme de lignes pour la connexion du substrat de silicium (1), et la première surface principale (2) comprenant une couche de dopage, la couche de dopage étant dopée avec une impureté de dopage, en particulier du phosphore, et comportant sensiblement un même profil de concentration sur toute la première surface principale (2) et/ou une même concentration superficielle sur toute la première surface principale (2), **caractérisée par** des voies de contact métalliques (8) sur la couche antireflet ou la couche de passivation (6) avec un écart W entre elles disposées de telles sorte que les voies de contact métalliques (8) sont en contact avec le substrat de silicium par plusieurs des ouvertures (7).

12. Cellule solaire selon la revendication 11, dans laquelle les ouvertures (7) présentent un écart de centre à centre D entre elles qui présente respectivement une valeur qui correspond au maximum à l'écart W entre les voies de contact métalliques, l'écart de centre à centre D et l'écart W entre les voies de contact métalliques présentant respectivement une valeur avec laquelle un rendement de la cellule solaire est maximal.
